# DEMANDE DE BREVET EUROPEEN

(11) **EP 4 297 090 A1**
(43) Date de publication de la demande: **27.12.2023**
(21) Numéro de dépôt: 23180759.5
(22) Date de dépôt: 21.06.2023
(51) Int. Cl.: H01L 27/12, H01L 29/786, H01L 21/8238, H01L 27/092

(54) **DISPOSITIF MICROÉLECTRONIQUE À DEUX TRANSISTORS À EFFET DE CHAMP**

(30) Priorité: 22.06.2022 FR 2206178
(71) Demandeur: Commissariat à l'énergie atomique et aux énergies alternatives, 75015 Paris (FR)
(72) Inventeur: BARRAUD, Sylvain, 38054 GRENOBLE Cedex 09 (FR); LACORD, Joris, 38054 GRENOBLE Cedex 09 (FR)
(74) Mandataire: Hautier IP

(57) **Abrégé**

L'invention concerne un dispositif microélectronique (1) comprenant un transistor n-MOS (100) à effet de champ, une première zone dopée N (110), constituant l'un parmi le drain et la source du transistor n-MOS et une deuxième zone dopée N (120), constituant l'autre parmi le drain et la source du transistor n-MOS. Le dispositif selon l'invention comprend en outre un transistor p-MOS (200) à effet de champ, une première zone dopée P (210), constituant l'un parmi le drain et la source du transistor p-MOS, une deuxième zone dopée P (220), constituant l'autre parmi le drain et la source du transistor p-MOS, une couche diélectrique (300) au contact des zones dopées et une grille arrière (400). Le transistor n-MOS et le transistor p-MOS sont séparés par une jonction PN (1000).

## Description

### DOMAINE TECHNIQUE

La présente invention concerne le domaine de la microélectronique et plus particulièrement les technologies CMOS (de l'anglais « Complementary Metal Oxide Semiconductor, pouvant se traduire en français par « métal-oxyde-semiconducteur complémentaires ») avancées. Elle trouve comme applications particulièrement avantageuses l'électronique basse consommation et les dispositifs de protection contre les décharges électrostatiques.

### ETAT DE LA TECHNIQUE

Différents types de transistors sont actuellement utilisés dans les circuits électroniques pour réaliser de nombreuses fonctions (circuits logiques, amplification, modulation de signaux...).

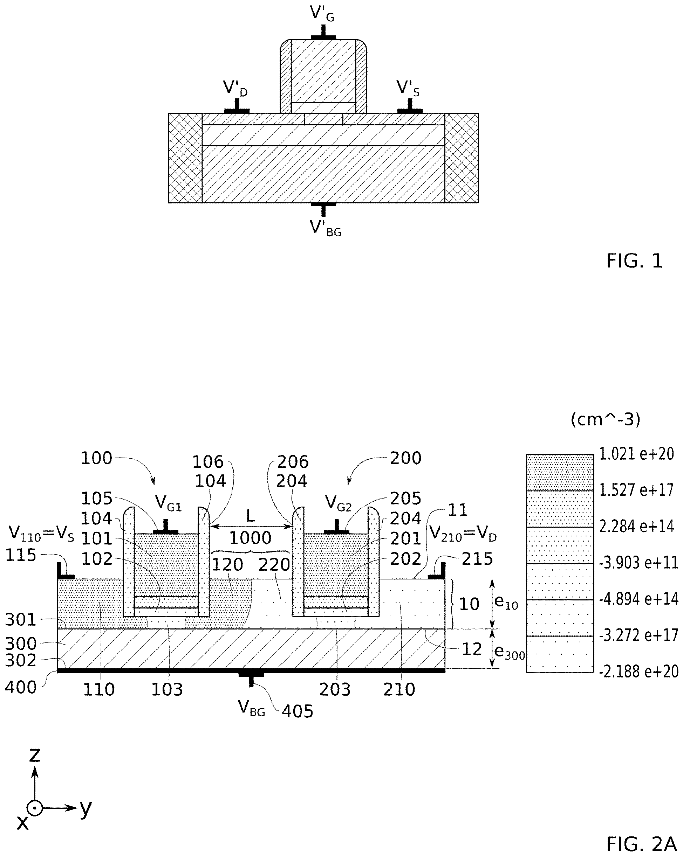

Une des structures les plus utilisées actuellement est le transistor FDSOI (de l'anglais « Fully Depleted Silicon On Insulator », pouvant être traduit en français par « silicium sur isolant entièrement déserté »), représenté en figure 1. Cette technologie consiste à placer une fine couche isolante sous la couche de semiconducteur, par exemple de silicium, de sorte à créer une barrière permettant notamment d'éviter les fuites de courant. Les transistors FDSOI sont privilégiés dans les applications basse consommation.

Les transistors Z²FET sont, eux, notamment employés pour des applications mémoire et de protection contre les décharges électrostatiques (ESD). Il s'agit d'une diode p-i-n polarisée en direct dont le canal intrinsèque est seulement partiellement recouvert par une grille avant.

Un objectif de la présente invention est de proposer une alternative aux dispositifs existants tout en présentant des performances au moins équivalentes et/ou en permettant de réaliser des fonctions pour lesquelles tous les dispositifs actuels ne peuvent pas être employés.

### RESUME

Pour atteindre cet objectif, un premier aspect concerne un dispositif microélectronique comprenant :
- un transistor n-MOS à effet de champ comprenant un premier drain, une première source, une première grille et un premier oxyde de grille,
- une première zone dopée N, constituant l'un parmi le premier drain et la première source,
- une deuxième zone dopée N, constituant l'autre parmi le premier drain et la première source.

Le dispositif comprend de plus :
- un transistor p-MOS à effet de champ comprenant un deuxième drain, une deuxième source, une deuxième grille et un deuxième oxyde de grille,
- une première zone dopée P, constituant la deuxième source si la première zone dopée N constitue le premier drain, ou le deuxième drain, si la première zone dopée N constitue la première source,
- une deuxième zone dopée P, constituant l'autre parmi le deuxième drain et la deuxième source,
- une couche diélectrique présentant une face supérieure au contact de la première zone dopée N, de la deuxième zone dopée N, de la première zone dopée P et de la deuxième zone dopée P,
- une grille arrière au contact d'une face inférieure de la couche diélectrique.

Il présente en outre la particularité que la deuxième zone dopée N et la deuxième zone dopée P forment une jonction PN.

L'objet ainsi défini constitue un dispositif microélectronique pouvant remplacer dans de nombreuses applications les transistors actuellement utilisés. Ce dispositif peut présenter en outre des performances améliorées. De manière avantageuse, il permet de générer une commutation abrupte grâce à la jonction PN, utilisable par exemple pour des dispositifs à pente élevée. Les niveaux de courant employés peuvent rester faible, si bien que cette technique convient bien aux systèmes électroniques à très faible consommation d'énergie.

Un deuxième objet concerne un procédé de contrôle du dispositif dans lequel la première tension de commande V₁₁₀ est appliquée à la première zone dopée N et la deuxième tension de commande V₂₁₀ est appliquée à la première zone dopée P, et dans lequel :
- La première tension de commande V₁₁₀ constitue une tension de source V_{S} du dispositif et la deuxième tension de commande V₂₁₀ constitue une tension de drain V_{D} du dispositif, ou
- La deuxième tension de commande V₂₁₀ constitue la tension de source V_{S} du dispositif et la première tension de commande V₁₁₀ constitue la tension de drain V_{D} du dispositif.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente un transistor FDSOI tel que connu de l'art antérieur.
Les figures 2A et 2B représentent chacune la cartographie du dopage au sein du dispositif selon un mode de réalisation de l'invention.
Les figures 3A et 3B représentent des caractéristiques courant-tension du dispositif selon l'un des modes de réalisation de l'invention obtenues par simulation.
La figure 3C est un tableau récapitulant les paramètres appliqués lors des simulations des figures 3A et 3B.
Les figures 4A et 4B représentent la répartition des charges au sein du dispositif respectivement dans une configuration bloquée (V_{BG}=1.7V) et dans une configuration passante (V_{BG}=1.8V).
La figure 4C est un tableau récapitulant les paramètres appliqués lors des simulations des figures 4A et 4B.
Les figures 5A et 5B représentent la répartition du potentiel électrostatique au sein du dispositif en configurations bloquée (V_{BG}=1.7V) et passante (V_{BG}=1.8V).
La figure 5C est un tableau récapitulant les paramètres appliqués lors des simulations des figures 5A et 5B.
Les figures 6A et 6B représentent des simulations du niveau des bandes de conduction et de valence du dispositif en configurations bloquée (V_{BG}=1.7V) et passante (V_{BG}=1.8V).
La figure 6C est un tableau récapitulant les paramètres appliqués lors des simulations des figures 6A et 6B.
Les figures 7A et 7B représentent la répartition du champ électrique dans la direction du transport au sein du dispositif en configurations bloquée (V_{BG}=1.7V) et passante (V_{BG}=1.8V).
La figure 7C est un tableau récapitulant les paramètres appliqués lors des simulations des figures 7A et 7B.
Les figures 8A et 8B représentent la répartition de la densité de courant des électrons au sein du dispositif en configurations bloquée (V_{BG}=1.7V) et passante (V_{BG}=1.8V).
La figure 8C est un tableau récapitulant les paramètres appliqués lors des simulations des figures 8A et 8B.
Les figures 9A, 9C et 9E représentent des caractéristiques courant-tension du dispositif obtenues respectivement en augmentant une deuxième tension de grille V_{G2} et en fixant une première tension de grille V_{G1} à une valeur de -0.5V, en augmentant la première tension de grille V_{G1} et en fixant la deuxième tension de grille V_{G2} à une valeur de -0.5V, et en diminuant la deuxième tension de grille.
Les figures 9B et 9D sont des tableaux récapitulant les paramètres appliqués lors des simulations des figures 9A, 9C et 9E.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le dispositif comprend en outre une première électrode et une deuxième électrode, la première zone dopée N est au contact de la première électrode qui est configurée pour recevoir une première tension de commande V₁₁₀ et la première zone dopée P est au contact de la deuxième électrode qui est configurée pour recevoir une deuxième tension de commande V₂₁₀.

Selon un exemple :
- La première tension de commande V₁₁₀ constitue une tension de source V_{S} du dispositif et la deuxième tension de commande V₂₁₀ constitue une tension de drain V_{D} du dispositif, ou
- La deuxième tension de commande V₂₁₀ constitue la tension de source V_{S} du dispositif et la première tension de commande V₁₁₀ constitue la tension de drain V_{D} du dispositif.

Selon un exemple, le dispositif comprend en outre une première électrode de grille et une deuxième électrode de grille, la première grille est au contact de la première électrode de grille qui est configurée pour recevoir l'application d'une première tension de grille V_{G1} et la deuxième grille est au contact de la deuxième électrode de grille qui est configurée pour recevoir l'application d'une deuxième tension de grille V_{G2}.

Selon un exemple, le dispositif comprend une électrode de grille arrière et la grille arrière est au contact de l'électrode de grille arrière qui est configurée pour recevoir l'application d'une tension de grille arrière V_{BG}.

Selon un mode de réalisation, le dispositif comprend en outre un circuit de contrôle configuré pour appliquer :
- la première tension de commande V₁₁₀ sur la première électrode,
- la deuxième tension de commande V₂₁₀ sur la deuxième électrode,
- la première tension de grille V_{G1} sur la première électrode,
- la deuxième tension de grille V_{G2} sur la deuxième électrode,
- la tension de grille arrière V_{BG} sur l'électrode de grille arrière,
la première tension de commande V₁₁₀, la deuxième tension de commande V₂₁₀, la première tension de grille V_{G1}, la deuxième tension de grille V_{G2} et la tension de grille arrière V_{BG} pouvant prendre différentes valeurs et au moins des valeurs comprises entre -5 et 5 V.

Selon un exemple, le circuit de contrôle est configuré pour pouvoir faire passer le dispositif d'une configuration passante, dans laquelle la jonction PN se trouve dans un état passant, à une configuration bloquée dans laquelle la jonction PN se trouve dans un état bloqué, ou inversement, ce en faisant varier la tension de grille arrière V_{BG} entre une tension de grille arrière ouverte V_{BG,ON} et une tension de grille arrière bloquée V_{BG,OFF} distincte de la tension de grille arrière ouverte V_{BG,ON}.

Selon un exemple, V_{G1}= V_{G2}+ΔV_{G} avec ΔV_{G} compris entre -1V et +1V.

Selon un exemple, V_{G1}<0.

Selon un exemple, V_{G2}<0.

Selon un exemple, V_{G1}>0 et V_{G2}>0.

Selon un exemple, V_{G1} = V_{G2}.

Selon un exemple, la jonction PN présente une tension de diffusion V_{bi}, et dans lequel la tension drain-source, définie par V_{D}-V_{S}, est supérieure à la tension de diffusion V_{bi}.

Selon un exemple, la tension de grille arrière V_{BG} est comprise entre -1 et 2 V.

Selon un exemple, le transistor n-MOS et le transistor p-MOS sont séparés d'une distance L supérieure à 10 nm, de préférence supérieure à 50nm, et/ou inférieure à 500 nm.

Un deuxième objet de l'invention concerne un procédé de contrôle du dispositif. Selon un exemple, le procédé prévoit de faire varier la tension de grille arrière V_{BG} entre une tension de grille arrière ouverte V_{BG,ON} et une tension de grille arrière bloquée V_{BG,OFF} distincte de la tension de grille arrière ouverte V_{BG,ON}, de sorte à faire passer le dispositif d'une configuration passante, dans laquelle la jonction PN se trouve dans un état passant, à une configuration bloquée dans laquelle la jonction PN se trouve dans un état bloqué.

Selon un exemple, le procédé prévoit l'application des tensions V_{G1} et V_{G2} de sorte que V_{G1}= V_{G2}+ΔV_{G} avec ΔV_{G} compris entre -1V et +1 V.

Selon un exemple, le procédé prévoit l'application des tensions V_{G1} et V_{G2} de sorte que V_{G1}>0 et V_{G2}>0.

Selon un exemple, le procédé prévoit l'application de la tension V_{G1} de sorte que V_{G1}<0.

Selon un exemple, le procédé prévoit l'application de la tension V_{G2} de sorte que V_{G2}<0.

Selon un exemple, le procédé prévoit l'application des tensions V_{G1} et V_{G2} de sorte que V_{G1} = V_{G2}.

Selon un exemple, le procédé prévoit l'application des tensions V₁₁₀ et V₂₁₀ de sorte que la tension drain-source, définie par V_{D}-V_{S}, soit supérieure à une tension de diffusion V_{bi} de la jonction PN.

Selon un exemple, le procédé prévoit l'application d'une tension de grille arrière V_{BG} comprise entre -1 et 2 V.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant, soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi un matériau à base d'un matériau III-N peut comprendre un matériau III-N additionné de dopants. De même, une couche à base de GaN comprend typiquement du GaN et des alliages d'AlGaN ou d'InGaN.

Le terme « matériau III-V » fait référence à un semi-conducteur composé d'un ou plusieurs éléments de la colonne III et de la colonne V du tableau périodique de Mendeleïev. On compte parmi les éléments de la colonne III le bore, le gallium, l'aluminium ou encore l'indium. La colonne V contient par exemple l'azote, l'arsenic, l'antimoine et le phosphore.

Un repère, de préférence orthonormé, comprenant les axes x, y, z est représenté en figure 2A. Ce repère est applicable par extension aux autres figures.

Dans la présente demande de brevet, on parlera préférentiellement d'épaisseur pour une couche et de hauteur pour une structure ou un dispositif. L'épaisseur est prise selon une direction normale au plan d'extension principal de la couche, et la hauteur est prise perpendiculairement au plan de base XY. Ainsi, une couche présente typiquement une épaisseur selon z, lorsqu'elle s'étend principalement le long d'un plan XY, et un élément en saillie, par exemple une tranchée d'isolation, présente une hauteur selon z. Les termes relatifs « sur », « sous », « sous-jacent » se réfèrent préférentiellement à des positions prises selon la direction z.

Les termes « sensiblement », « environ », « de l'ordre de » signifient « à 10% près, de préférence à 5% près ».

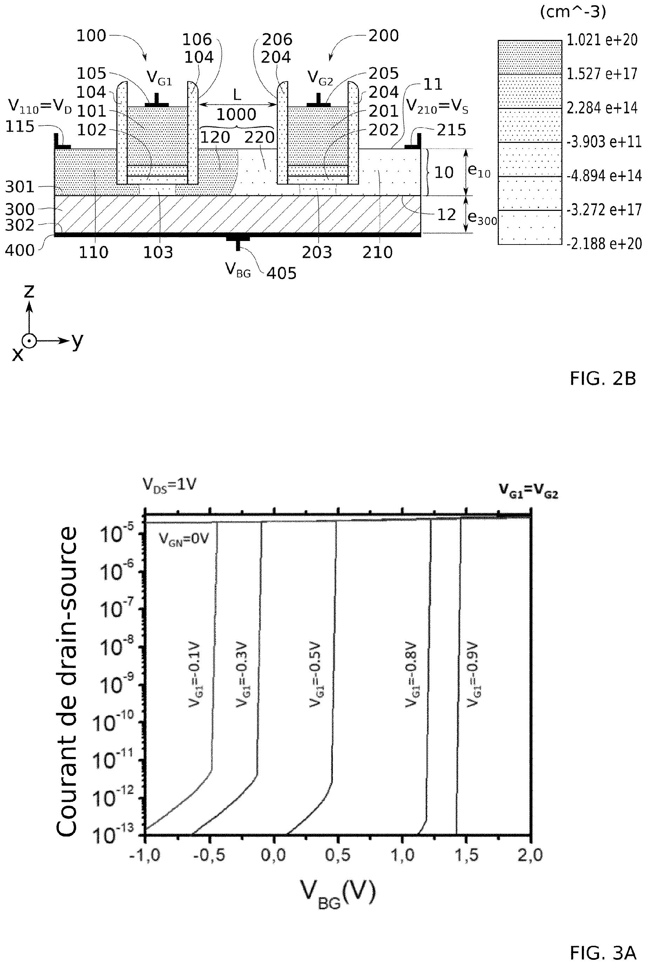

Le dispositif selon différents modes de réalisation de l'invention va maintenant être décrit en référence aux figures 2A et 2B.

Le dispositif 1 comprend deux transistors à effet de champ : l'un du type n-MOS 100, et l'autre du type p-MOS 200. De préférence, il ne comprend pas d'autres transistors ou pour le moins pas d'autres transistors joints à l'un ou l'autre des deux premiers par une jonction PN.

Le transistor n-MOS 100 comprend un premier drain, une première source, une première grille 101 et un premier oxyde de grille 102.

Le premier oxyde de grille 102 s'étend sous la première grille 101. La première zone dopée N 110 et la deuxième zone dopée N 120 sont chacune en contact avec un premier canal 103, dit de conduction mais qui peut aussi être une zone désertée de porteurs, les séparant. Ce premier canal 103 est au contact de la face inférieure du premier oxyde de grille 102. Le premier canal 103 présente avantageusement une épaisseur selon la direction z comprise entre 5 et 10 nm, typiquement sensiblement égale à 7 nm.

Le transistor n-MOS 100 comprend de plus typiquement des espaceurs 104 permettant d'isoler la première grille 101 du premier drain d'une part et de la première source d'autre part. Ces espaceurs 104 couvrent typiquement les flancs latéraux de la première grille 101. Ils sont entre autres destinés à limiter le couplage capacitif parasite entre la première grille 101 et la première source d'une part et le premier drain d'autre part.

Le transistor p-MOS 200 comprend un deuxième drain, une deuxième source, une deuxième grille 201, un deuxième oxyde de grille 202 et un deuxième canal 203 lui aussi dit de conduction mais pouvant aussi être une zone désertée de porteurs. Les caractéristiques du transistor n-MOS 100 peuvent être transposées mutatis mutandis au transistor p-MOS 200.

Le transistor n-MOS 100 et le transistor p-MOS 200 sont séparés d'une distance L mesurée dans le plan XY et définie comme la distance entre un flanc 106 du transistor n-MOS 100 et un flanc 206 du transistor p-MOS 200 lui faisant face. Les flancs 106, 206 des transistors 100, 200 correspondent typiquement aux flancs des espaceurs 104, 204. La distance L est de préférence, pour des raisons de limitations technologiques lors de la fabrication du dispositif, supérieure à 50 nm. Il serait cependant envisageable dans les applications visées que la distance L soit fixée à des valeurs aussi faibles que 10 nm. Dans un objectif d'optimisation de la densité de dispositifs pouvant être intégrés sur une puce, elle est de préférence inférieure à 500 nm.

Le dispositif comprend de plus une première zone dopée N 110 et une deuxième zone dopée N 120. La première zone dopée N 110 et la deuxième zone dopée N 120 peuvent constituer respectivement le premier drain et la première source, ou inversement.

De manière similaire, le dispositif comprend une première zone dopée P 210 et une deuxième zone dopée P 220 pouvant constituer respectivement le deuxième drain et la deuxième source, ou inversement.

La deuxième zone dopée N 120 et la deuxième zone dopée P 220 sont en contact et forment ainsi une jonction PN 1000. La jonction PN 1000 présente une tension de diffusion, couramment désignée par le terme anglais de tension de « built-in », notée V_{BI} et dont la valeur dépend notamment du niveau de dopage des zones 120, 220 la constituant.

Les zones dopées 110, 120, 210, 220 se trouvent de préférence toutes dans une couche active 10. La couche active 10 est de préférence à base d'au moins un matériau IV-IV. Il peut également être à base d'au moins un matériau III-V, de préférence à base d'au moins un matériau III-N. Par exemple, ce matériau est à base de GaN. Ce matériau peut également être à base de silicium. Il peut s'agir d'une couche homogène, formée typiquement d'un unique matériau. La couche active 10 présente typiquement une face supérieure 11 et une face inférieure 12 s'étendant toutes les deux principalement dans le plan XY du repère orthogonal XYZ. Elle présente selon la direction z une épaisseur e₁₀. L'épaisseur e₁₀ de la couche active 10 est avantageusement comprise entre 20 et 30 nm, typiquement sensiblement égale à 25 nm.

Certains éléments constituant les transistors 100, 200 peuvent avoir été au moins partiellement formés à partir d'une couche continue dite couche de fabrication. Par exemple, certaines régions de la couche de fabrication auront pu être oxydées pour former les oxydes de grille 102, 202 et/ou les espaceurs 104, 204. La couche de fabrication peut également avoir été gravée puis différents dépôts auront pu être réalisés sur cette couche de fabrication afin de former les oxydes de grille 102, 202, espaceurs 104, 204 et/ou grilles 101, 201. Les régions non transformées ou gravées de la couche de fabrication font alors partie de la couche active 10. La couche active 10 peut de plus comprendre des zones ayant été épitaxiées à partir de la couche de fabrication.

Afin de réaliser une jonction PN 1000 fonctionnelle, dans le cas où la deuxième zone dopée N 120 constitue le premier drain, la deuxième zone dopée P 220 constitue la deuxième source. En conséquence, la première zone dopée N 110 constitue alors la première source et la première zone dopée P 220 constitue le deuxième drain. Dans ce cas de figure, la première zone dopée N 110 constitue la source et la première zone dopée P 220 le drain du dispositif 1.

A l'inverse, dans le cas où la deuxième zone dopée N 120 constitue la première source, la deuxième zone dopée P 220 constitue le deuxième drain. En conséquence, la première zone dopée N 110 constitue alors le premier drain et la première zone dopée P 220 constitue la deuxième source. Dans ce cas de figure, la première zone dopée N 110 constitue le drain et la première zone dopée P 220 la source du dispositif 1.

Le dispositif 1 comprend de plus une couche diélectrique 300 présentant une face supérieure 301 et une face inférieure 302 s'étendant toutes les deux principalement dans des plans parallèles au plan XY du repère orthogonal. La face supérieure 301 de la couche diélectrique 300 se trouve au contact de la première zone dopée N 110, de la deuxième zone dopée N 120, de la première zone dopée P 210 et de la deuxième zone dopée P 220. La couche diélectrique 300 constitue ainsi un diélectrique enterré commun aux deux transistors 100, 200 et donc de façon générale un diélectrique enterré pour le dispositif 1. Elle présente selon la direction z une épaisseur e₃₀₀ typiquement égale à 25 nm. Cette valeur correspond aux standards de l'industrie microélectronique. L'invention peut cependant parfaitement fonctionner pour d'autres valeurs de e₃₀₀. La valeur de la tension de grille arrière V_{BG} sera ajustée en fonction de la valeur de e₃₀₀ : plus la couche diélectrique 300 sera épaisse, plus la tension de grille arrière à appliquer sera élevée.

Le dispositif 1 comprend en outre une grille arrière 400 au contact de la face inférieure 302 de la couche diélectrique 300.

Le dispositif 1 peut comprendre les électrodes ou reprises de contact suivantes :
- une première électrode 115 au contact de la première zone dopée N 110,
- une deuxième électrode 215 au contact de la première zone dopée P 210,
- une première électrode de grille 105 au contact de la première grille 101,
- une deuxième électrode de grille 205 au contact de la deuxième grille 201,
- une électrode de grille arrière 405 au contact de la grille arrière 400,
chacune de ces électrodes étant configurée pour pouvoir recevoir l'application d'une tension. Ces électrodes sont typiquement des couches métalliques déposées au contact de chacune des zones dopées 110, 210 et grilles 101, 201, 400.

Plus précisément, on prévoit notamment que puissent être appliquées :
- une première tension de commande V₁₁₀ sur la première électrode 115,
- une deuxième tension de commande V₂₁₀ sur la deuxième électrode 215,
- une première tension de grille V_{G1} sur la première électrode 105,
- une deuxième tension de grille V_{G2} sur la deuxième électrode 205,
- une tension de grille arrière V_{BG} sur l'électrode de grille arrière 405.

De préférence, toutes les électrodes 115, 215, 105, 205 et 405 sont accessibles - c'est-à-dire que des tensions peuvent leur être appliquées -depuis une même face dite face avant du dispositif 1. Dans cette optique, la grille arrière 400 fait avantageusement saillie par rapport à la couche diélectrique 300 de sorte à permettre une reprise de contact de ladite grille arrière 400 depuis la face avant du dispositif 1. La couche diélectrique 300 peut en outre, au niveau de cette reprise de contact, présenter une surépaisseur. Cette surépaisseur correspond typiquement à la somme de l'épaisseur e₃₀₀ de la couche diélectrique 300 et de l'épaisseur e₁₀ de la couche active 10. L'électrode de grille arrière 405 se trouve alors de niveau selon la direction z avec la première électrode 115 et la deuxième électrode 215. Cela permet de faciliter leur fabrication simultanée. On prévoit alors avantageusement la présence d'au moins une tranchée d'isolation peu profonde (couramment désignée STI, acronyme anglais de « Shallow Trench Isolation ») permettant d'isoler électriquement la grille arrière 400 de la couche active 10.

Ainsi, le comportement du dispositif 1 peut être contrôlé au niveau de cinq points de commande. Les transistors FDSOI, couramment utilisés dans l'industrie microélectronique, qui présentent une unique grille en face avant, ne peuvent être contrôlés qu'au niveau de quatre points de commande (drain, source, grille avant, grille arrière, visibles sur la figure 1). Grâce à ce point de commande supplémentaire, il est possible de contrôler plus finement le comportement électrique du dispositif 1 par rapport à un transistor FDSOI classique. Cela confère également au dispositif 1 des fonctionnalités supplémentaires et permet de l'utiliser pour d'autres applications, comme cela sera détaillé plus avant.

La première tension de commande V₁₁₀ et la deuxième tension de commande V₂₁₀ constituent pour le dispositif 1 respectivement une tension de drain V_{D} et une tension de source V_{S}, ou inversement. Plus précisément :
- Si la première zone dopée N 110 constitue la première source et la première zone dopée P 210 le deuxième drain, alors la première tension de commande V₁₁₀ constitue la tension de source V_{S} du dispositif 1 et la deuxième tension de commande V₂₁₀ constitue la tension de drain V_{D} du dispositif 1. Ce cas de figure est envisagé à la figure 2A.
- Si la première zone dopée N 110 constitue le premier drain et la première zone dopée P 210 la deuxième source, alors la première tension de commande V₁₁₀ constitue la tension de drain V_{D} du dispositif 1 et la deuxième tension de commande V₂₁₀ constitue la tension de source V_{S} du dispositif 1. Ce cas de figure est envisagé à la figure 2B.

Dans le premier cas de figure, la source du dispositif 1 se trouve au niveau d'une zone dopée N et le drain au niveau d'une zone dopée P. Dans cette configuration, le dispositif 1 en fonctionnement aura donc un comportement global de type n-MOS. A l'inverse, dans le second cas de figure, la source du dispositif 1 se trouve au niveau d'une zone dopée P et le drain au niveau d'une source dopée N. Le dispositif 1 en fonctionnement aura donc cette fois un comportement global de type p-MOS.

Il est à noter que la fonction de source ou de drain des zones 110, 120, 210 et 220 dépend des tensions qui leur sont appliquées, et plus exactement du signe des tensions V₁₁₀-V₁₂₀ et V₂₁₀-V₂₂₀. Ainsi, il est possible de faire passer le dispositif 1 d'un comportement n-MOS à un comportement p-MOS, et inversement, en changeant simplement le signe de ces différences de tension. Le dispositif 1 constitue ainsi un dispositif à commutation vertical (souvent désigné par le terme anglais de « sharp switch device »).

La tension de grille arrière joue, elle, dans le dispositif 1, un rôle majeur de commande.

Le dispositif 1 en fonctionnement peut se trouver dans une configuration dite passante ou dans une configuration dite bloquée.

Dans la configuration bloquée, la jonction PN 1000 se trouve dans un état bloqué. Elle présente une zone de charge d'espace, ou zone de déplétion, comprenant des charges fixes mais dans laquelle les charges libres ne peuvent pas circuler. Une barrière de potentiel sépare ainsi le transistor n-MOS 100 et le transistor p-MOS 200 et empêche la circulation du courant entre la source et le drain du dispositif 1. Cette configuration bloquée du dispositif 1 peut également être appelée « état OFF » du dispositif 1.

Dans la configuration passante du dispositif 1, la jonction PN 1000 se trouve dans un état passant. Il n'y a donc pas de barrière de potentiel entre le transistor n-MOS 100 et le transistor p-MOS 200. En conséquence, l'ensemble formé par le premier canal de conduction 103, la jonction PN 1000 et le deuxième canal de conduction 203 est traversé par des charges circulant librement entre la source et le drain du dispositif. Le courant peut donc circuler dans le dispositif 1. Cette configuration passante du dispositif 1 peut être désignée « état ON » du dispositif 1.

Le passage de la configuration bloquée à la configuration passante du dispositif 1, ou inversement, se fait par commutation de la jonction PN 1000. Une telle jonction se caractérise notamment par sa rapidité de commutation, ce qui confère au dispositif 1 lui-même une excellente efficacité de passage de l'état ON à l'état OFF et inversement. C'est ce qui va par la suite être caractérisé en référence aux figures 3A à 8C.

Le fait qu'une faible variation de tension permette de faire passer le dispositif d'un état à l'autre permet de garantir une forte efficacité énergétique. Le dispositif 1 peut donc être utilisé dans des applications électroniques de très faible consommation énergétique. Cela permet de plus d'améliorer ses performances en termes de rapidité de réponse à une sollicitation extérieure. Cette caractéristique est ainsi à l'origine de plusieurs avantages importants du dispositif 1.

Toutes les simulations présentées dans les figures 3A à 8C allant maintenant être décrites ont été réalisées pour un dispositif 1 dans lequel la première zone dopée N 110 constitue la source du transistor n-MOS 100 et la première zone dopée P 210 constitue le drain du transistor p-MOS 200 (comportement de type n-FET). La tension drain-source V_{DS}=V_{D}-V_{S} du dispositif 1 est donc définie par V₂₁₀-V₁₁₀. Il est à noter que des simulations portant sur un dispositif 1 présentant un comportement p-FET permettraient de tirer de enseignements similaires sur son efficacité.

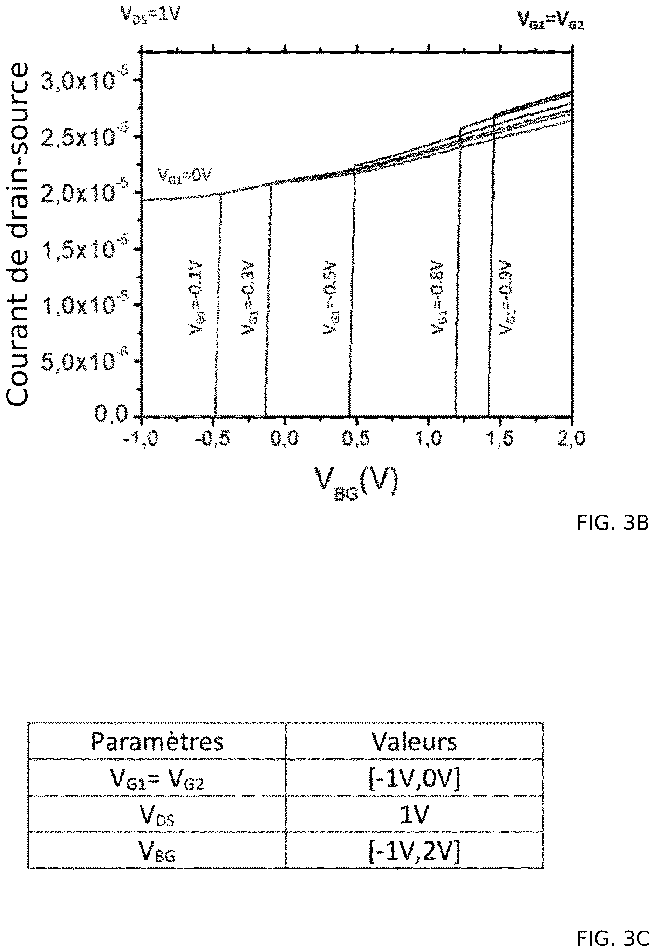

Les figures 3A et 3B montrent les caractéristiques courant-tension I_{D}=f(V_{BG}), respectivement en échelles logarithmique et linéaire, obtenues par simulation TCAD (de l'anglais « Technology Computer Aided Design », pouvant être traduit en français par « conception technologique assistée par ordinateur ») du dispositif 1. Au cours de cette simulation :
- la première tension de grille V_{G1} et la deuxième tension de grille V_{G2} ont été fixées à une même valeur positive. La simulation a été réalisées pour plusieurs valeurs de V_{G1}=V_{G2}, variant de -1V à 0V. Ces différentes simulations correspondent aux différentes courbes sur les figures 3A et 3B.
- la tension drain-source V_{DS} a été fixée à une valeur de 1V. Cette valeur est notamment supérieure à la tension de built-in, ou tension de diffusion, de la jonction PN 1000.
- la tension de grille arrière V_{BG} varie de -1V à 2V.
- on relève l'évolution du courant de drain-source I_{DS} circulant dans le dispositif 1 en fonction de V_{BG}.

Ces éléments sont récapitulés dans le tableau présenté en figure 3C.

Ces figures témoignent d'une commutation abrupte du courant (comportement parfois désigné par le terme anglais « steep slope », pouvant être traduit par « pente raide »). Une variation de la tension de grille arrière V_{BG} de quelques mV (1mV=10⁻³V) seulement permet une variation de jusqu'à huit décades de courant. Cela correspond à une pente sous le seuil pouvant des valeurs aussi faibles que 1mV/dec. A titre de comparaison, la pente sous le seuil des transistors FDSOI couramment utilisés dans l'industrie est généralement de l'ordre de 80mV/dec. Le dispositif 1 selon l'invention permet donc d'atteindre des performances bien supérieures aux transistors FDSOI classiques.

Par exemple, pour V_{G1}=V_{G2}=-0,9V, une variation d'un courant d'environ 10⁻⁵A à un courant d'environ 10⁻¹³A est obtenue pour une variation de V_{BG} de moins de 50mV.

Il est à noter que la tension de grille arrière à laquelle le dispositif 1 commute V_{BG,commutation} peut être réglée sur une large plage de tension, ici d'environ -0,5V à près de 1,5V, en ajustant la tension appliquée sur la première grille 101 et la deuxième grille 201. Ainsi, le dispositif 1 peut être utilisé pour différentes applications par simple paramétrage des tensions V_{G1} et V_{G2}.

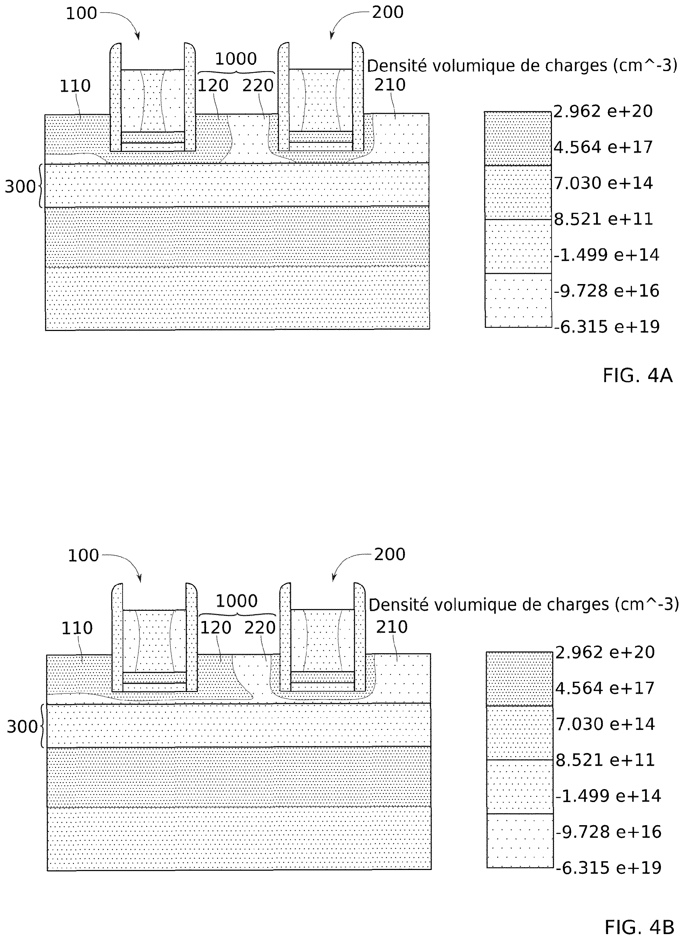

Les figures 4A et 4B sont des cartographies représentant la répartition des charges au sein du dispositif 1 en configurations bloquée (figure 4A) et passante (figure 4B).

Au cours de cette simulation :
- la première tension de grille V_{G1} et la deuxième tension de grille V_{G2} ont été fixées à une même valeur de -1V.
- la tension drain-source V_{DS} a été fixée à une valeur de 1V.
- la tension de grille arrière V_{BG} est fixée une première fois à 1,7V (figure 4A) et une fois à 1,8V (figure 4B).
- on relève la densité de charge volumique, exprimée en C.m⁻³, en tout point du dispositif.

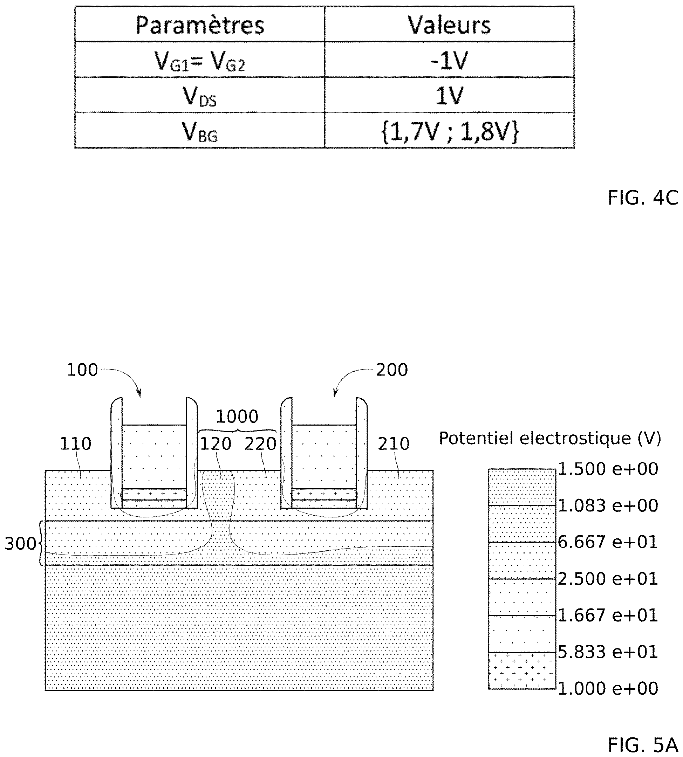

Ces éléments sont récapitulés dans le tableau présenté en figure 4C.

Ces cartographies permettent notamment d'observer l'évolution de la zone de charge d'espace de la jonction PN 1000. On observe que celle-ci crée une barrière de potentiel sur toute la hauteur de la jonction lorsque V_{BG}=1,7V (figure 4A), qui cède quand la tension de grille arrière atteint une valeur de 1,8V (figure 4B). On observe en effet sur la figure 4B, contre la face supérieure 301 de la couche diélectrique 300, une zone continue présentant une densité de charges de l'ordre de 10¹⁹C/m³. C'est notamment à travers cette zone que le courant de drain-source I_{DS} circule une fois le dispositif commuté. Ces deux figures illustrent ainsi la commutation de la jonction PN 1000 et par conséquent celle du dispositif 1.

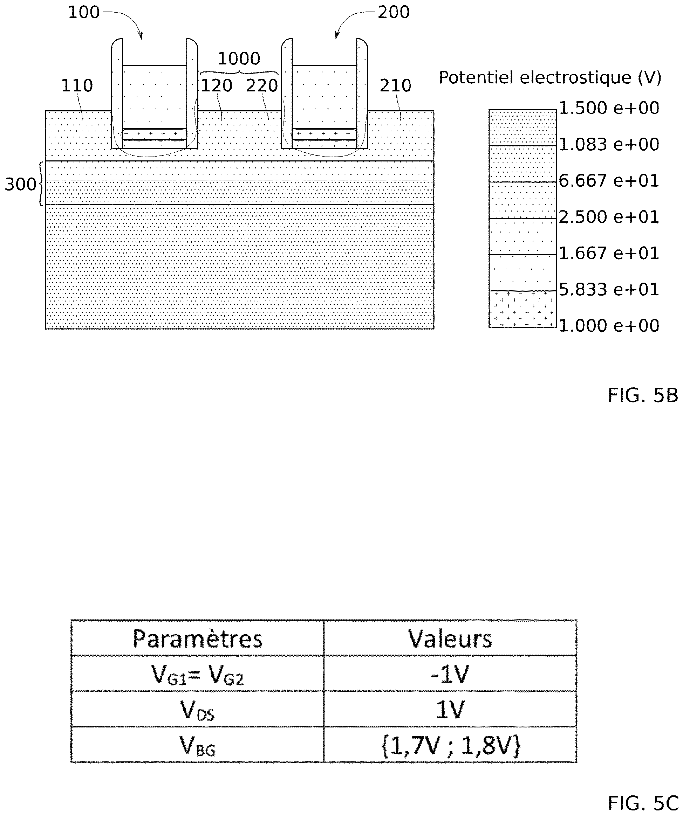

Les figures 5A et 5B montrent des cartographies représentant la répartition du potentiel électrostatique au sein du dispositif 1 en configurations bloquée (figure 5A) et passante (figure 5B). Les paramètres de simulation sont identiques à ceux des simulations illustrées aux figures 4A et 4B, comme indiqué en figure 5C. On observe sur la figure 5A une très forte différence de potentiel électrostatique entre la deuxième zone dopée N 120 et la deuxième zone dopée P 220 formant la jonction PN 1000, témoignant de la barrière de potentiel régnant dans la jonction PN 1000. Après commutation et passage à la configuration passante, cette différence de potentiel disparaît, ce qui permet au courant de circuler entre la source et le drain du dispositif.

Il est à noter que les figures 5A et 5B témoignent du fait qu'une commutation peut être obtenue en faisant varier V_{BG} de 100mV, mais il a été montré qu'une variation de moins de 10mV peut suffire pour observer le même phénomène.

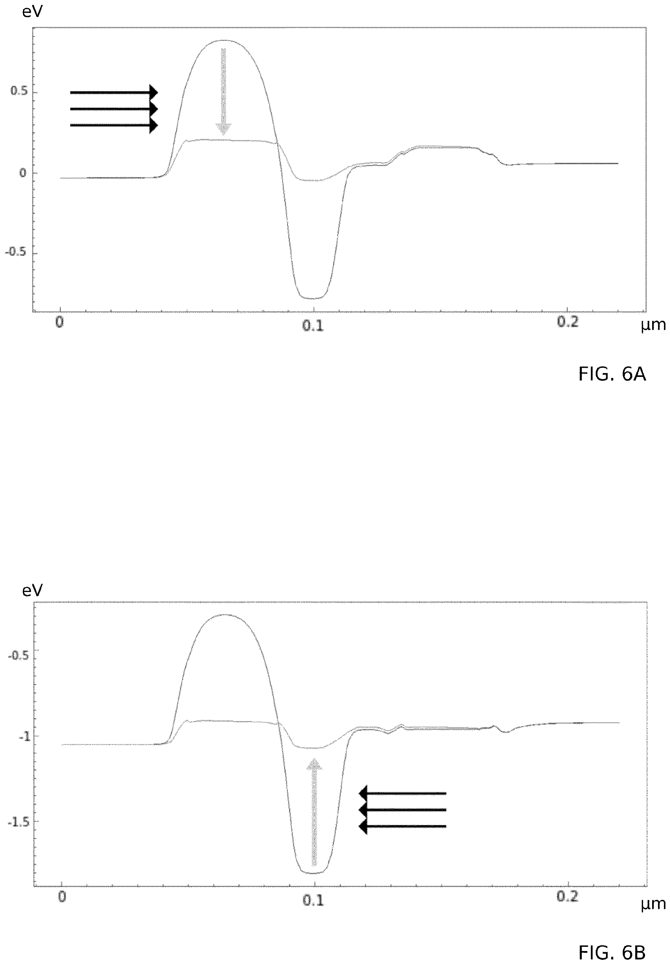

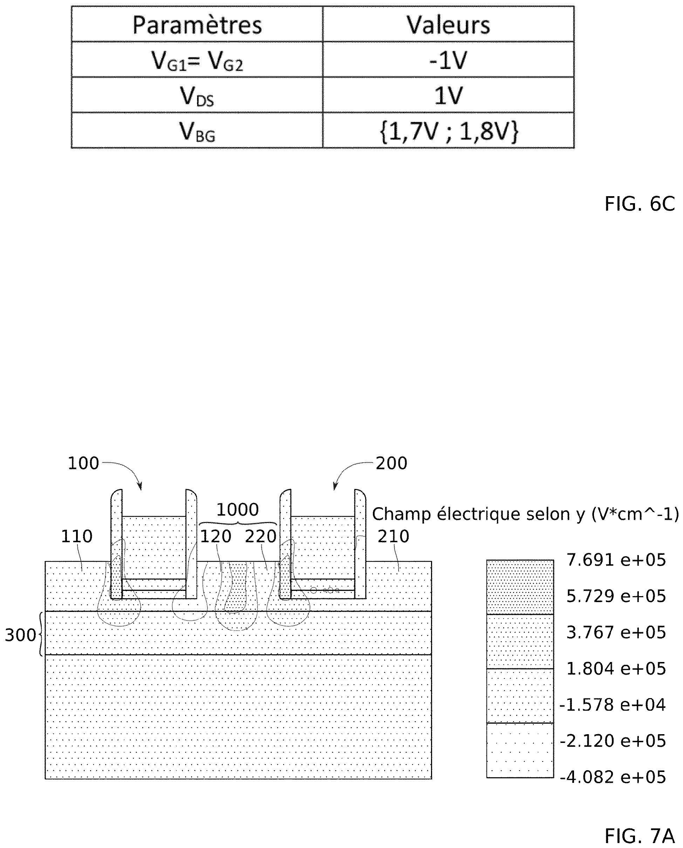

Les figures 6A et 6B représente des simulations du niveau des bandes de conduction (figure 6A) et de valence (figure 6B) entre la source et le drain du dispositif 1 en configurations bloquée (courbes gris foncé) et passante (courbes gris clair). Les paramètres de simulation sont identiques à ceux des simulations illustrées aux figures 4A et 4B, comme indiqué en figure 6C. On observe que dans la configuration bloquée, la bande de conduction présente, au niveau de la deuxième zone dopée N 120, une barrière de potentiel bloquant le passage des électrons de la source au drain. Pour une valeur de V_{BG} correspondant à la configuration passante du dispositif 1, cette barrière est abaissée et le courant peut circuler. Un phénomène similaire se produit pour la bande de valence : en configuration bloquée, la bande de valence présente, au niveau de la deuxième zone dopée P 220, une barrière de potentiel bloquant le passage des trous du drain à la source du dispositif 1. Après commutation de la configuration bloquée à la configuration passante, la barrière de potentiel est abaissée et le courant peut circuler. Ces figures démontrent à nouveau qu'une commutation abrupte du dispositif 1 est permise grâce au passage soudain de la jonction PN 1000 de l'état bloqué à l'état passant, ou inversement.

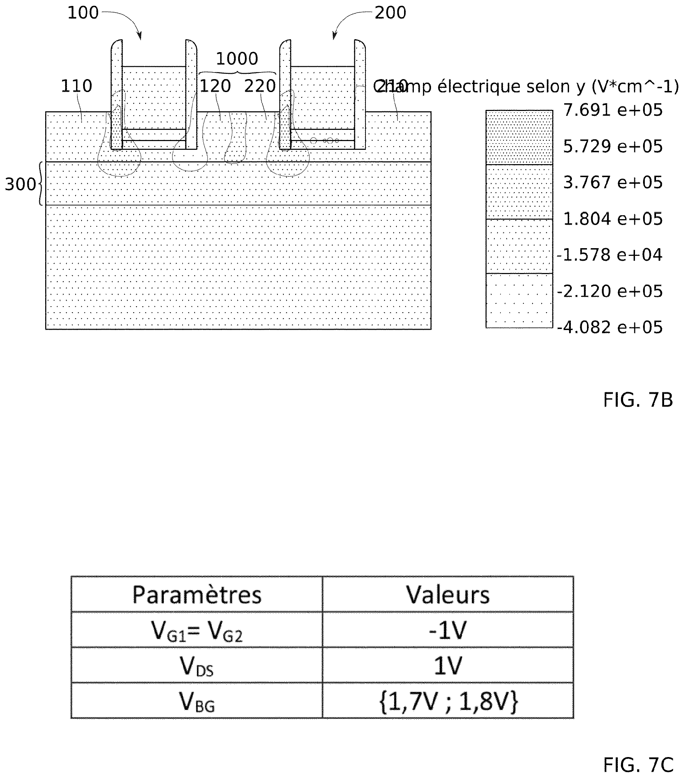

Les figures 7A et 7B montrent des cartographies représentant la répartition du champ électrique selon la direction Y au sein du dispositif 1 en configurations bloquée (figure 7A) et passante (figure 7B). Les paramètres de simulation sont identiques à ceux des simulations illustrées aux figures 4A et 4B, comme indiqué en figure 7C. La commutation se traduit par un champ électrique latéral fort au niveau de la jonction PN 1000 à l'état OFF et un champ électrique pratiquement nul à l'état ON du dispositif 1.

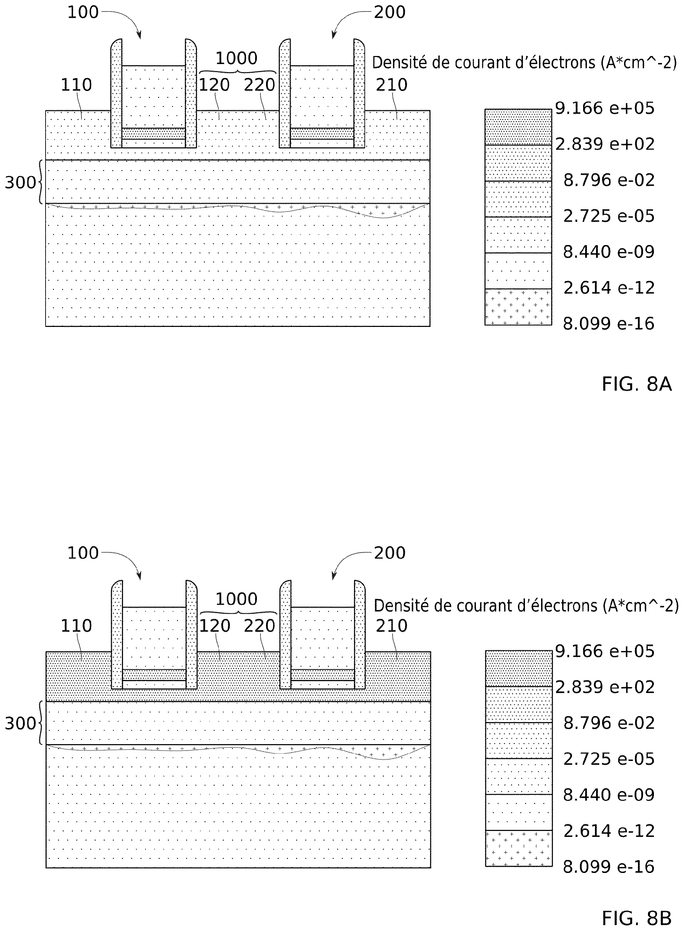

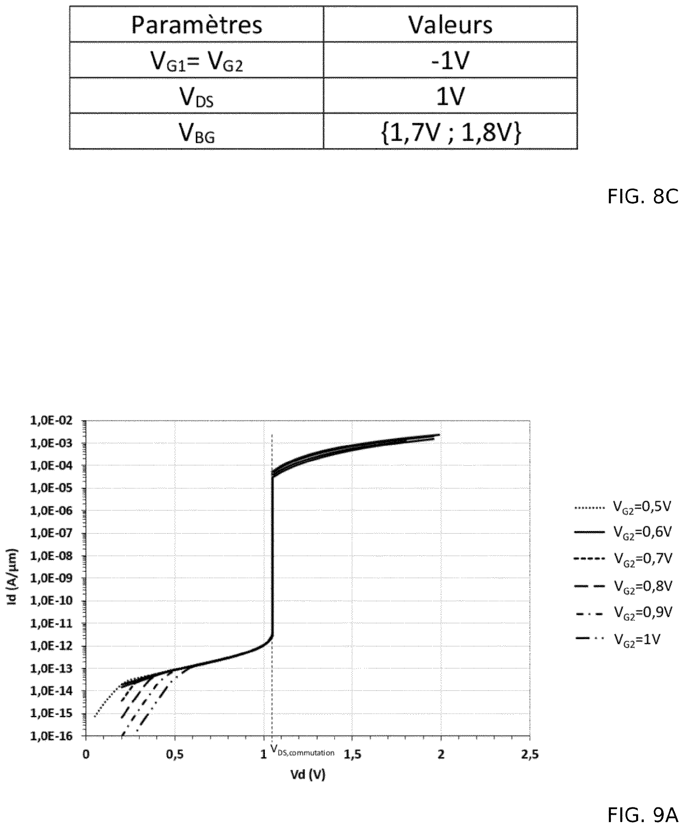

Les figures 8A et 8B montrent des cartographies représentant la répartition de la densité de courant des électrons au sein du dispositif 1 en configurations bloquée (figure 8A) et passante (figure 8B). Une très forte augmentation de la densité de courant a lieu après commutation du dispositif 1 de l'état OFF à l'état ON.

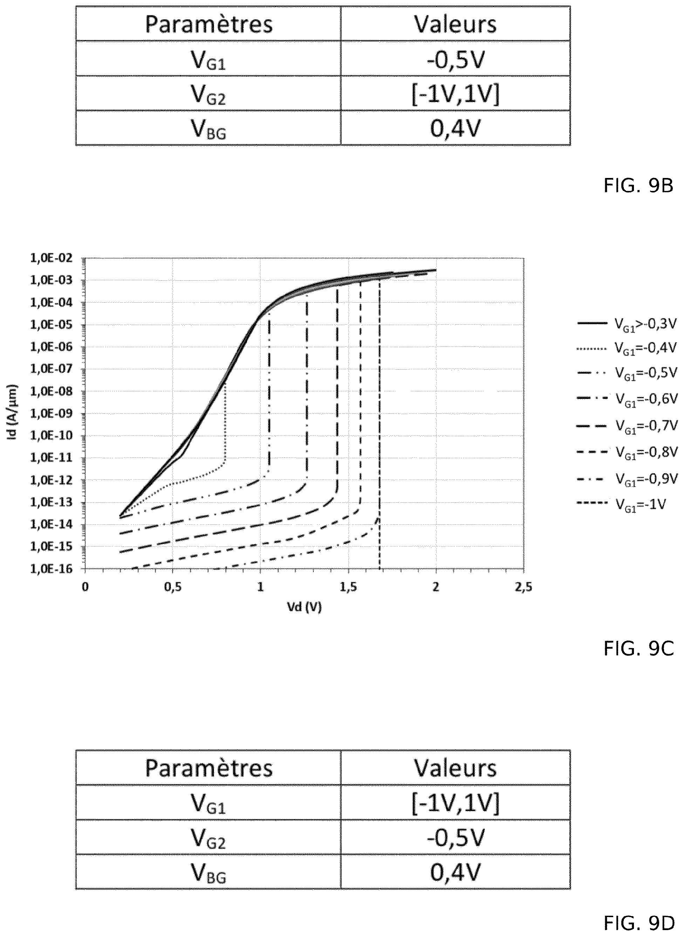

Les caractéristiques venant d'être étudiées en référence aux figures 3A à 8C ont été obtenues en fixant la valeur des tensions de grille V_{G1} et V_{G2} et en faisant varier la tension de grille arrière V_{BG}. Elles ont permis de montrer qu'une commutation abrupte pouvait être obtenue pour la caractéristique courant-tension I_{DS}=f(V_{BG}). Une commutation abrupte peut cependant également être obtenue pour la caractéristique courant-tension I_{DS}=f(V_{DS}). C'est ce qui est illustré aux figures 9A à 9D.

Tout d'abord, la figure 9A montre une étude de la caractéristique courant-tension I_{DS}=f(V_{DS}) en fonction de la deuxième tension de grille V_{G2}.

Au cours de cette simulation :
- la première tension de grille V_{G1} est fixée à -0,5V.
- la tension drain-source V_{DS} varie de 0V à 2V.
- la tension de grille arrière V_{BG} a été fixée à 0,4V.
- on relève l'évolution du courant de drain-source I_{DS} circulant dans le dispositif 1 en fonction de V_{DS} et ce pour différentes valeurs de V_{G2} comprises entre -1V et 1V correspondant à autant de courbe sur la figure 9A.

On observe qu'une commutation abrupte du courant drain-source I_{DS} est obtenue autour d'une tension de commutation V_{DS,commutation}=1.05V, et ce quelle que soit la tension V_{G2} appliquée sur la grille du transistor p-MOS.

La figure 9C montre ensuite une étude de la caractéristique courant-tension I_{DS}=f(V_{DS}) en fonction de la première tension de grille V_{G1}. Au cours de cette simulation :
- la deuxième tension de grille V_{G2} est fixée à -0,5V.
- la tension drain-source V_{DS} varie de 0V à 2V.
- la tension de grille arrière V_{BG} a été fixée à 0,4V.
- on relève l'évolution du courant de drain-source I_{DS} circulant dans le dispositif 1 en fonction de V_{DS} et ce pour différentes valeurs de V_{G1} comprises entre -1V et 1V correspondant à autant de courbe sur la figure 9C.

On observe qu'une commutation abrupte du courant drain-source I_{DS} est obtenue à la condition que la première tension de grille V_{G1} se trouve dans la bonne plage de valeurs. Dans le cas présent, il faut que V_{G1}<-0,3V. En dessus de ce seuil, i.e. pour V_{G1}>-0,3V, la première tension de grille n'est pas suffisante pour former la barrière de potentiel au niveau de la jonction PN 1000 entre le drain du transistor n-MOS 100 et la source du transistor p-MOS 200. Le dispositif 1 ne présente alors pas de commutation abrupte et a un comportement semblable à celui d'une diode PIN. Pour V_{G1}<-0,3V, la première tension de grille est suffisante pour former la barrière de potentiel au niveau de la jonction PN 1000. Une commutation abrupte est observée et a lieu pour une tension drain-source V_{DS} d'autant plus forte que la première tension de grille V_{G1} est faible. En effet, plus V_{G1} est faible, plus la barrière de potentiel est grande, plus la tension drain-source nécessaire à la faire disparaître est élevée et donc plus la tension de commutation V_{DS,commutation} est élevée.

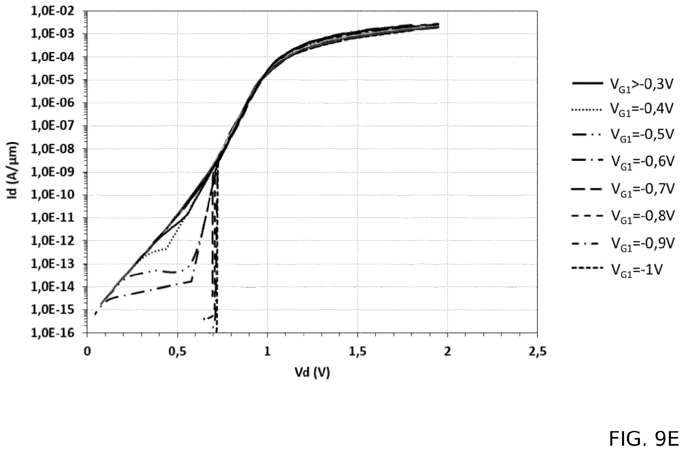

La figure 9E illustre la caractéristique courant-tension I_{DS}=f(V_{DS}) obtenue par une simulation similaire à celle ayant permis d'obtenir la figure 9C, mais au cours de laquelle la tension drain-source V_{DS} varie de 2V à 0V et non de 0V à 2V. Il s'agit donc d'une caractéristique communément appelée « backward » ou « reverse », tandis que la caractéristique représentée à la figure 9C constitue son pendant « forward ».

On remarque que, pour chacune des valeurs de première tension de grille V_{G1} étudiée, la tension de commutation V_{DS,commutation} est différente en mode « backward » et en mode « forward ». La tension de commutation V_{DS,commutation,BW} en mode backward est notamment ici inférieure à la tension de commutation V_{DS,commutation,FW} en mode forward. Ces deux figures mettent donc en évidence un phénomène d'hystérésis, qui peut être mis à profit dans des applications mémoires.

Selon un mode de réalisation, le dispositif 1 comprend un circuit de contrôle permettant d'appliquer les tensions précédemment mentionnées sur chacune de ces électrodes. Le circuit de contrôle permet en outre de faire varier les tensions V₁₁₀, V₂₁₀, V_{G1}, V_{G2} et V_{BG}, par exemple dans une plage donnée telle que [-5V, 5V].

Le circuit de contrôle est avantageusement configuré pour pouvoir faire passer le dispositif 1 de la configuration passante à la configuration bloquée et inversement.

L'invention n'est pas limitée aux modes de réalisations précédemment décrits et s'étend à tous les modes de réalisation couverts par l'invention.

## Revendications

1. Dispositif microélectronique (1) comprenant :
• un transistor n-MOS (100) à effet de champ comprenant un premier drain, une première source, une première grille (101) et un premier oxyde de grille (102),
• une première zone dopée N (110), constituant l'un parmi le premier drain et la première source,
• une deuxième zone dopée N (120), constituant l'autre parmi le premier drain et la première source,
**caractérisé en ce qu'**il comprend en outre :
• un transistor p-MOS (200) à effet de champ comprenant un deuxième drain, une deuxième source, une deuxième grille (201) et un deuxième oxyde de grille (202),
• une première zone dopée P (210), constituant la deuxième source si la première zone dopée N (110) constitue le premier drain, ou le deuxième drain, si la première zone dopée N (110) constitue la première source,
• une deuxième zone dopée P (220), constituant l'autre parmi le deuxième drain et la deuxième source,
• une couche diélectrique (300) présentant une face supérieure (301) au contact de la première zone dopée N (110), de la deuxième zone dopée N (120), de la première zone dopée P (210) et de la deuxième zone dopée P (220),
• une grille arrière (400) au contact d'une face inférieure (302) de la couche diélectrique (300),
et **en ce que** la deuxième zone dopée N (120) et la deuxième zone dopée P (220) forment une jonction PN (1000).

2. Dispositif (1) selon la revendication précédente comprenant une première électrode (115) et une deuxième électrode (215), et dans lequel la première zone dopée N (110) est au contact de la première électrode (115) qui est configurée pour recevoir une première tension de commande V₁₁₀ et la première zone dopée P (210) est au contact de la deuxième électrode (215) qui est configurée pour recevoir une deuxième tension de commande V₂₁₀.

3. Dispositif (1) selon la revendication précédente dans lequel :
• La première tension de commande V₁₁₀ constitue une tension de source V_{S} du dispositif (1) et la deuxième tension de commande V₂₁₀ constitue une tension de drain V_{D} du dispositif (1), ou
• La deuxième tension de commande V₂₁₀ constitue la tension de source V_{S} du dispositif (1) et la première tension de commande V₁₁₀ constitue la tension de drain V_{D} du dispositif (1).

4. Dispositif (1) selon l'une quelconque des revendications précédentes comprenant une première électrode de grille (105) et une deuxième électrode de grille (205), et dans lequel la première grille (101) est au contact de la première électrode de grille (105) qui est configurée pour recevoir l'application d'une première tension de grille V_{G1} et la deuxième grille (201) est au contact de la deuxième électrode de grille (205) qui est configurée pour recevoir l'application d'une deuxième tension de grille V_{G2}.

5. Dispositif (1) selon l'une quelconque des revendications précédentes comprenant une électrode de grille arrière (405) et dans lequel la grille arrière (400) est au contact de l'électrode de grille arrière (405) qui est configurée pour recevoir l'application d'une tension de grille arrière V_{BG}.

6. Dispositif (1) selon les revendications 2 à 5 en combinaison comprenant en outre un circuit de contrôle configuré pour appliquer :
• la première tension de commande V₁₁₀ sur la première électrode (115),
• la deuxième tension de commande V₂₁₀ sur la deuxième électrode (215),
• la première tension de grille V_{G1} sur la première électrode (105),
• la deuxième tension de grille V_{G2} sur la deuxième électrode (205),
• la tension de grille arrière V_{BG} sur l'électrode de grille arrière (405),
la première tension de commande V₁₁₀, la deuxième tension de commande V₂₁₀, la première tension de grille V_{G1}, la deuxième tension de grille V_{G2} et la tension de grille arrière V_{BG} pouvant prendre différentes valeurs et au moins des valeurs comprises entre -5 et 5 V.

7. Dispositif (1) selon la revendication précédente dans lequel le circuit de contrôle est configuré pour pouvoir faire passer le dispositif (1) d'une configuration passante, dans laquelle la jonction PN (1000) se trouve dans un état passant, à une configuration bloquée dans laquelle la jonction PN (1000) se trouve dans un état bloqué, ou inversement, ce en faisant varier la tension de grille arrière V_{BG} entre une tension de grille arrière ouverte V_{BG,ON} et une tension de grille arrière bloquée V_{BG,OFF} distincte de la tension de grille arrière ouverte V_{BG,ON}.

8. Dispositif (1) selon la revendication précédente dans lequel V_{G1}= V_{G2}+ΔV_{G} avec ΔV_{G} compris entre -1V et +1V.

9. Dispositif (1) selon l'une quelconque des deux revendications précédentes dans lequel V_{G1}<0.

10. Dispositif (1) selon l'une quelconque des trois revendications précédentes, dans lequel V_{G2}<0.

11. Dispositif (1) selon l'une quelconque des revendications 7 et 8, dans lequel V_{G1}>0 et V_{G2}>0.

12. Dispositif (1) selon l'une quelconque des revendications 7 à 11, dans lequel V_{G1} = V_{G2}.

13. Dispositif (1) selon l'une quelconque des revendications 7 à 12, dans lequel la jonction PN présente une tension de diffusion V_{bi}, et dans lequel la tension drain-source, définie par V_{D}-V_{S}, est supérieure à la tension de diffusion V_{bi}.

14. Dispositif (1) selon l'une quelconque des revendications 7 à 13, dans lequel la tension de grille arrière V_{BG} est comprise entre -1 et 2 V.

15. Dispositif (1) selon l'une quelconque des revendications précédentes dans lequel le transistor n-MOS (100) et le transistor p-MOS (200) sont séparés d'une distance L supérieure à 10 nm, de préférence supérieure à 50nm, et/ou inférieure à 500 nm.

16. Procédé de contrôle du dispositif (1) selon l'une quelconque des revendications 2 à 15 dans lequel la première tension de commande V₁₁₀ est appliquée à la première zone dopée N (110) et la deuxième tension de commande V₂₁₀ est appliquée à la première zone dopée P (210), et dans lequel :
• La première tension de commande V₁₁₀ constitue une tension de source V_{S} du dispositif (1) et la deuxième tension de commande V₂₁₀ constitue une tension de drain V_{D} du dispositif (1), ou
• La deuxième tension de commande V₂₁₀ constitue la tension de source V_{S} du dispositif (1) et la première tension de commande V₁₁₀ constitue la tension de drain V_{D} du dispositif (1).

17. Procédé de contrôle du dispositif (1) selon la revendication précédente dans lequel le dispositif comprend une électrode de grille arrière (405), la grille arrière (400) est au contact de l'électrode de grille arrière (405) qui est configurée pour recevoir l'application d'une tension de grille arrière V_{BG}, et dans lequel la tension de grille arrière V_{BG} varie entre une tension de grille arrière ouverte V_{BG,ON} et une tension de grille arrière bloquée V_{BG,OFF} distincte de la tension de grille arrière ouverte V_{BG,ON}, de sorte à faire passer le dispositif (1) d'une configuration passante, dans laquelle la jonction PN (1000) se trouve dans un état passant, à une configuration bloquée dans laquelle la jonction PN (1000) se trouve dans un état bloqué.
